# EUROPEAN PATENT APPLICATION

(11) **EP 3 719 855 A1**
(43) Date of publication of application: **07.10.2020**
(21) Application number: 20167448.8
(22) Date of filing: 01.04.2020
(51) Int. Cl.: H01L 31/043, H02S 40/38, H01L 31/05, H01L 25/04

(54) **CONSTRUCTION SYSTEM TO CREATE A PHOTOVOLTAIC PANEL MADE UP OF A PLURALITY OF LAYERS**

(30) Priority: 02.04.2019 CH 4382019
(71) Applicant: Fedenergy SA, 6900 Paradiso (CH)
(72) Inventor: Chiacchieroni, Alfredo, 05010 San Venanzo (IT); Scaramuzzino, Carmelo, 6855 Stabio (CH)
(74) Representative: Pasquino, Fabio

(57) **Abstract**

The present invention relates to a photovoltaic module (1) comprising: support means (2); at least a photovoltaic group (4, 8) mounted on said support means (2), configured to convert at least a solar type radiation (3) incident on said photovoltaic group (4, 8) into electric energy, and comprising at least a plurality of photovoltaic cells (4) electrically connected to each other in at least a plurality of series connection (5) in turn electrically connected to each other in at least a parallel connection (6), said parallel connection (6) is electrically connected to storage means (7) of the electric charge produced by said photovoltaic group and is configured to supply said storage means (7) with a recharge current or a recharge voltage of predefined value;
a plurality of semiconductor conversion elements (8) of the photovoltaic diodes type and electrically connected to each other in at least a plurality of series connections (9) in turn electrically connected to each other in at least parallel connection (10), said parallel connection (10) is electrically connected to said storage means (7) and is configured to supply said storage means (7) with a recharge voltage suitable to cooperate with said recharge current or, vice versa, a recharge current able to cooperate with said recharge voltage to recharge said storage means (7).

## Description

### Field of the invention

The present invention refers to a photovoltaic module and a related manufacturing process capable of storing the solar energy received through a multilayer construction method capable of maximizing the transformation into electric energy.

### State of the art

Various photovoltaic modules are known, generally used for the conversion of radiation of the type of solar radiation into electrical energy. The known photovoltaic modules comprise a plurality of photovoltaic cells defining at least one conversion surface into electric energy of the solar radiation incidents the module itself.

The photovoltaic cells comprise a P-N junction whose generation of electron-hole pairs is stimulated by the solar radiation incidents on the cell itself, consequently, the migration of the electron-hole pairs generates a cell current that passes through the same photovoltaic cell and generates at the ends of the latter a corresponding cell voltage.

Known modules comprise a combination of electrical connections in series and in parallel of a plurality of said photovoltaic cells with the aim of providing a user with an output current and an output voltage of predefined value.

To support what is described in the previous paragraph, the values of the output voltage and output current of a series connection of a plurality of photovoltaic cells correspond respectively to the sum of the cell voltages of each photovoltaic cell of the series connection and to the cell current of a single photovoltaic cell that runs throughout the series connection, on the contrary, the value of the output current and output voltage of a parallel connection of a plurality of photovoltaic cells correspond respectively to the sum of the cell currents of each photovoltaic cell of the parallel connection and to the cell voltage of a single photovoltaic cell.

In this way, the photovoltaic cells are electrically connected to each other in a combination of series and parallel connections as a function of the number of cells of the photovoltaic panel and as a function of the voltage and the output current to be obtained.

Modules of this type can be connected to the domestic electricity grid in order to instantly use the energy produced by the module itself, these modules generally include a DC-AC converter device connected to the national electricity distribution grid.
In this way, the electric energy that is not instantly consumed by the domestic electricity grid can be supplied to the national electricity grid.

To date, the known photovoltaic modules are connected to storage means provided with a plurality of batteries configured to store the electric charge produced by the photovoltaic module and to reuse it, according to the needs, at a later time, however, this kind of modules are susceptible of improvements related to the charging efficiency of the storage means, in fact, the charging speed of the storage means is severely limited by the number of batteries to be recharged and by the number of photovoltaic cells used for charging, in particular it is convenient to electrically connect the batteries in series to each other with the aim of maximize the charging time of the storage means. In fact, in this way, it is possible to use a single output current to charge all the batteries, however, on the other hand, it is necessary to apply a particularly high output voltage to the ends of the batteries connected in series, at least equal to the sum of the rated voltages supplied by each battery.

In the photovoltaic modules of know type, the voltage and current output value of the photovoltaic module depends on the number of photovoltaic cells of the module itself and on the combination of series and parallel connections of the same photovoltaic cells; in fact, ideally, the parallel connection of all the photovoltaic cells of the module generates an output current of a value able to charge the batteries very quickly, but simultaneously it generates an output voltage across the batteries which does not allow this output current to recharge the storage means; on the contrary, the series connection of all the photovoltaic cells of the module generates an output voltage of a value able to recharge a particularly large number of batteries in series, but at the same time generates an output current which would use unacceptably long battery recharging times.

In light of these considerations, the photovoltaic modules of know type, with the aim of recharging a significant number of batteries in reasonably short times, must include an ever increasing number of photovoltaic cells or, alternatively, an ever increasing number of photovoltaic modules, with an increase in the taken up area as consequence and an increase in the cost of the plants as well.

### Summary of the invention

The main purpose of the present invention is to build a photovoltaic module and a related process to manufacture a photovoltaic module which allow the module itself to recharge a greater number of batteries than modules of known types while maintaining the same taken up area.

A further object of the present invention is to have a photovoltaic module and a relative process to manufacture a photovoltaic module which allow the module itself to recharge the storage means faster and more efficiently than modules of known types.

Another object of the present invention is to have a photovoltaic module and a related process to manufacture a photovoltaic module which allow to overcome the aforementioned drawbacks of the prior art in the context of a simple, rational, easy and effective use and low-cost solution.

The above-mentioned objects are achieved by the photovoltaic module according to the present invention having features as for the attached claims.

Furthermore, the objects set out above are achieved by the present process to manufacture a photovoltaic module having features as for the attached claims.

### Figures

These and further features and advantages of the present invention will become apparent from the disclosure of the preferred embodiment of a photovoltaic module and of a related process to manufacture a photovoltaic module, illustrated by way of a non-limiting example in the accompanying figure, wherein:
- **Figure 1****:** is a schematic front view of an embodiment of the electrical connections of the conversion elements of the photovoltaic module according to the invention;
- **Figure 2****:** is a schematic front view of an alternative embodiment of the electrical connections of the conversion elements of the photovoltaic module according to the invention;
- **Figure 3****:** is a schematic front view of the electrical connections of the photovoltaic cells of the photovoltaic module according to the invention;
- **Figure 4****:** is a schematic front view of a further embodiment of the electrical connections of some conversion elements;
- **Figure 5****:** is a schematic side section view of the photovoltaic module according to the invention;
- **Figure 6****:** is a circuit diagram of the electrical connection of the photovoltaic module according to the invention.
- **Figure 7****:** it is a multi-switch module to control the overproduction by checking the series and parallel connection of the photovoltaic cells.

### Descrizione dettagliata

With reference to the aformentioned Figures, a photovoltaic module is numbered as 1.

The photovoltaic module 1 comprises:
- support means 2;
- at least a photovoltaic group 4, 8 mounted on said support means 2, configured to convert at least a solar type radiation 3 incident on said photovoltaic group into electric energy, and comprising at least a plurality of photovoltaic cells 4 electrically connected to each other in at least a plurality of series connection 5 in turn electrically connected to each other in at least a parallel connection 6 (the connection of at least one serial or parallel connection can be deferred to the connection between the modules), said parallel connection is electrically connected to storage means 7 (the series or parallel connection can also be found with the combination of multiple modules) of the electric charge produced by said photovoltaic group and is configured to supply the storage means 7 with a recharge current or a recharge voltage of predefined value.

The photovoltaic group 4, 8 comprises:
- a plurality of semiconductor conversion elements 8 of the photovoltaic diodes type and electrically connected to each other in at least a plurality of series connections 9 in turn electrically connected to each other in at least parallel connection 10, said parallel connection is electrically connected to the storage means 7 and is configured to supply said storage means with a recharge voltage suitable to cooperate with said recharge current or, vice versa, a recharge current able to cooperate with said recharge voltage to recharge said storage means 7.

In the following, the term *"photovoltaic cell"* relates to a photovoltaic cell of the type commonly used for the construction of photovoltaic modules of know types to one skilled in the art.

In the following, the conversion elements 8 are photovoltaic diodes operating in the infrared field and which, according to the invention, are used as solar cells, in this way, the conversion elements 8 allow module 1 to generate energy even in the presence of an overcast sky. In fact, the radiation in the infrared band, between the wavelengths of 700 nm and 1 mm, propagates without being absorbed by the atmosphere as much as the radiation in the visible band.

However, alternative embodiments of the module 1 in which the converter elements 8 are of a different type, for example in which the conversion elements are operating in the visible field, are not excluded.

Conveniently, the voltage and the charging current are substantially independent to each other. In fact, the voltage and the charging current are supplied to the storage means 7 respectively by the conversion elements 8 and by the photovoltaic cells 4.

Furthermore, in the following and in order to describe a specific embodiment of the module 1 according to the invention, each conversion element 8, once affected by the radiation 3, generates a cell voltage of about 2 volts and a current of cell of about 0.6 milliamps. Instead, each photovoltaic cell 4, once affected by radiation 3, generates a cell voltage of about 0.6 volts and a cell current of about 4 amperes.

However, alternative embodiments of the module 1 in which the currents and voltages of the conversion elements 8 and of the photovoltaic cells 4 have different values are not excluded.

In particular, the photovoltaic cells 4 are arranged side by side and define an incidence surface 11 of the radiation 3 to be converted into electric energy.

Furthermore, the conversion elements 8 are conveniently associated with the incidence surface 11, in other words, the conversion elements 8 are superimposed on the photovoltaic cells 4, wherein preferably the size of a conversion element 8 is particularly limited with respect to the size of a photovoltaic cell 4.

According to the invention, the absorption surface of a conversion element 8 onto which the radiation 3 must affect has an area of smaller dimensions than the area of the absorption surface of a photovoltaic cell 4.

With the term *"absorption surface",* herewith used with reference to the photovoltaic cells 4 and to the conversion elements 8, is intended the surface occupied by each of the latter including the surface of the same which must be exposed to radiation 3 for the production of electric energy.

The module 1 comprises a plurality of conversion elements 8 arranged on the photovoltaic cells 4 without occupying the entire absorption surface thereof. Preferably, the absorption surface of the photovoltaic cells 4 has a substantially square shape, instead, the absorption surface of the conversion elements 8 preferably has a substantially rectangular shape.

However, alternative embodiments of the module 1 in which the absorption surfaces of the photovoltaic cells 4 and of the conversion elements 8 have different conformations, for example in which the absorption surface of the photovoltaic cells 4 has a rectangular conformation and the absorption surface of the conversion elements 8 has a square shape, are not excluded.

According to the embodiments of the module 1 shown in the Figures, each photovoltaic cell 4 has an absorption surface which measures approximately 16 x 16 centimeters, and each conversion element 8 has an absorption surface which measures approximately 4 x 1 centimeter.

However, alternative embodiments of the module 1 in which the photovoltaic cells 4 and the conversion elements 8 have an absorption surface having different sizes, for example where the photovoltaic cells 4 have an absorption surface measuring 13 x 13, are not excluded.

In the embodiment of the module 1 shown in the figures, twelve conversion elements 8 are arranged on each photovoltaic cell 4, however, alternative embodiments of the module 1 in which a different number of conversion elements 8, such as fifteen, six or three conversion elements 8, are not excluded.

The module 1 comprises at least one thickness element 16 interposed between the incidence surface 11 and the conversion elements 8, in particular, the thickness element 16 is made of a transparent material with respect to the radiation 3; in this way, the conversion elements 8 are not directly arranged on the incidence surface 11, or rather on the photovoltaic cells 4, in fact, the thickness element 16 has the purpose of spacing the incidence surface 11 from the conversion elements 8 by a predefined distance, and to allow the radiation 3 to affect the entire absorption surface of the photovoltaic cells 4.

A radiation 3 which affects the photovoltaic group 4, 8 can pass through the thickness element 16 and also directly irradiate the portions of the incidence surface 11 underlying the conversion elements 8.

The thickness element 16 is a layer of transparent material with respect to radiation 3, for example as EVA (Ethylene Vinyl Acetate), with a thickness equal to approximately 1 mm defining the predefined distance between the incidence surface 11 and the conversion elements 8. However, alternative embodiments of the module 1 in which the thickness element 16 has different thicknesses, for example less than or greater than 1 millimeter, so as to respectively reduce or increase the predefined distance, are not excluded.

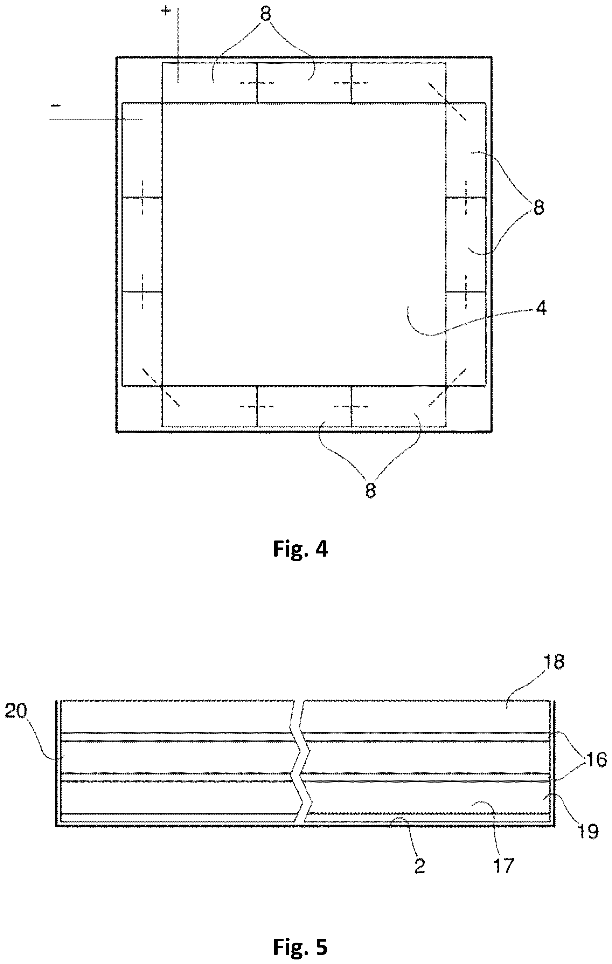

A possible embodiment of the module 1 is shown in Figure 5, wherein the module itself comprises a plurality of layers arranged one on top of the other to define the thickness of the module 1.
In particular, module 1 comprises, one after the other, the following layers:
- at least a support layer 17 defining the base layer for the subsequent layers;
- at least a photovoltaic layer 19 defined by photovoltaic cells 4;
- at least a layer defined by a first thickness element 16;
- at least a converting layer 20 defined by the conversion elements 8;
- at least a layer defined by a second thickness element 16;
- at least a layer of photovoltaic glass 18 able to define the top portion of the module 1 to be directly exposes to the radiation 3.

In this embodiment, the support layer 17 has a thickness equal to about 1 millimeter, the photovoltaic layer 19 has a thickness equal to about 4 millimeters, the layer defined by the first thickness element 16 has a thickness equal to about 1 millimeter, the converting layer 20 has a thickness of about 4 millimeters, the layer defined by the second thickness element 16 has a thickness of about 1 millimeter, and the photovoltaic glass layer has a thickness of about 4 millimeters; however, alternative embodiments of the module 1 in which a different number of layers are provided or in which these layers have thicknesses of different sizes, for example in which the layers defined by the thickness element 16 have a thickness greater than 1 millimeter, are not excluded.

At least part of the conversion elements 8 are arranged in a regular way along a plurality of columns substantially parallel to each other.

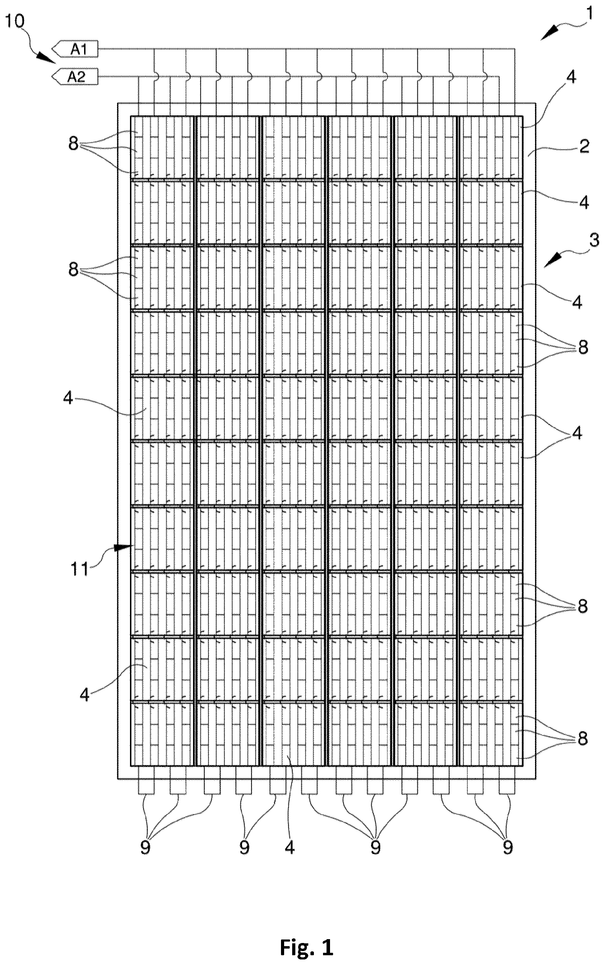

According to the particular embodiment of the module 1 shown in Figure 1, the module 1 comprises 720 conversion elements 8 arranged in 24 columns each of which comprises 30 conversion elements 8 and arranged parallel to each other while resting on the thickness element 16, below which 60 photovoltaic cells 4 are in turn arranged in columns of 10 cells defining an incidence surface 11 with a dimension approximately of 1.6 x 0.96 meters. In more detail, in this embodiment, each row coincides with a series connection 9 of 30 conversion elements 8.

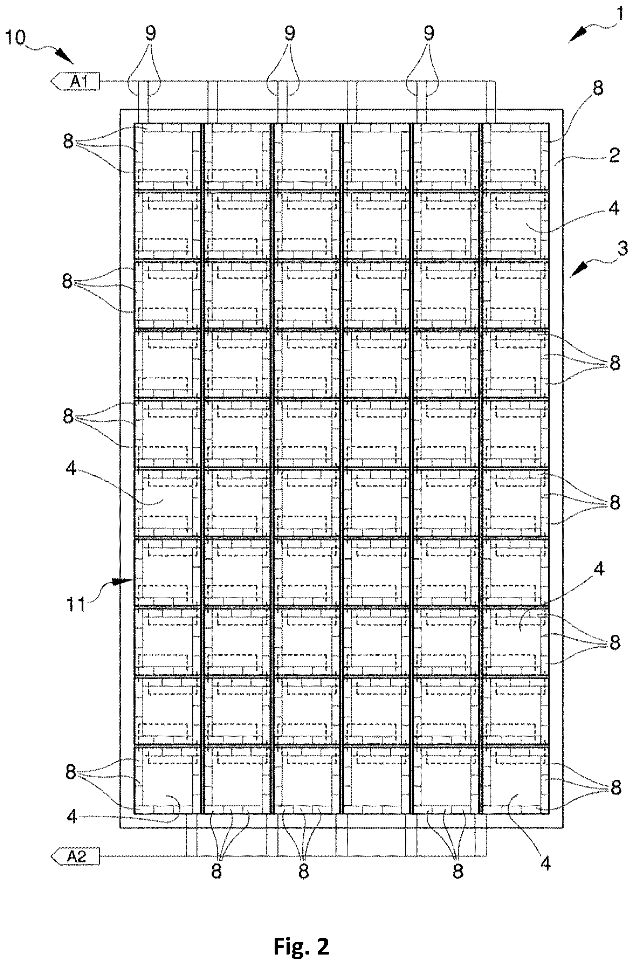

In an alternative embodiment of the module 1 shown in Figure 2, at least part of the conversion elements 8 are arranged in a regular way along a plurality of rows substantially parallel to each other and substantially transverse to the plurality of columns; in particular, unlike the shape of embodiment previously described, in this embodiment the module 1 comprises 360 conversion elements 8 arranged in 12 columns each of which comprises 30 conversion elements 8 and 360 conversion elements 8 arranged in 12 rows each of which comprises 30 conversion elements 8 and arranged substantially orthogonal to the previous 12 columns, in more detail, each column is spaced from the others by a distance equal to approximately the width of each photovoltaic cell 4, and each row is spaced from the others by a distance equal to approximately the height of each photovoltaic cell 4; in this way, each photovoltaic cell 4 is substantially framed by 12 conversion elements 8.

In the present embodiment, the 12 conversion elements 8 are arranged substantially along the perimeter of each photovoltaic cell 4, wherein this arrangement of the conversion elements 8 allows to maximize the absorption surface exposed to the radiation 3 of each photovoltaic cell 4. Furthermore, in this embodiment each series connection 9 comprises the 6 conversion elements 8 arranged along half the perimeter of 10 photovoltaic cells 4, as shown in figure 2. However, alternative embodiments of the electrical connection of the connection elements 8, for example like the one shown in figure 4, where the 12 conversion elements 8 surrounding each single photovoltaic cell 4 are connected in series to each other in connection groups, which are in turn electrically connected to each other to define the connections in 9 series and parallel connections 10, are not excluded.

The embodiments of the module 1 in the Figures show a module 1 having an extension of about a meter and a half in height by a meter in width, that is, to date, an extension comparable with the extensions of the photovoltaic modules of the type known to one skilled in the art.

The storage means 7 comprise a plurality of electric charge accumulators 12 electrically connected in series to each other, moreover, the parallel connection 10 is electrically connected in parallel to the electric charge accumulators 12 electrically connected in series; in this way, the conversion elements 8 are connected to the positive pole of the first electric charge accumulator 12 of the series and to the negative pole from the last electric charge accumulator 12 of the series.

This connection allows the charging voltage to be applied to the ends of the series of electric charge accumulators 12; in fact, according to the embodiment of the module 1 shown in the Figures, the conversion elements 8 are connected together in 12 series connections 9, each comprising 60 conversion elements 8 and in turn connected together in a single parallel connection 10; in this way, the parallel connection 10 applies a charging voltage of about 120 volts to the storage means 7, furthermore, the parallel connection 10 also applies to the storage means 7 a predefined current of about 7.2 milliamps, which, however, would take particularly long times to recharge the storage means 7.

Preferably, the electric charge accumulators 12 are batteries of the know types to one skilled in the art.

According to the particular embodiment of the module 1 shown in the Figures, the storage means 7 comprise nine batteries electrically connected in series to each other. However, alternative embodiments of the module 1 in which the latter is electrically connected to storage means 7 comprising a number of batteries of different types of batteries, for example twelve, six or three batteries, are not excluded.

According to the invention, the electric charge accumulators 12 are preferably batteries from 12 volts to 18 amps, however, alternative embodiments of the module 1 in which the batteries have different voltage and amperage, for example as 12 volts at 24 amperes, are not excluded.
In particular, according to the invention, the series connections 5 are electrically connected to each other in a plurality of parallel connections 6, each of which is electrically connected in parallel to a corresponding predefined number of electric charge accumulators 12.
In particular, at least one parallel connection 6 is electrically connected in parallel to a predefined number of accumulators of electric charge 12 different from the predefined number of accumulators of electric charge 12 electrically connected in parallel to another of the parallel connections 6.
This expedient allows the module 1 to recharge the electric charge accumulators 12 in a particularly fast way; in fact, each parallel connection 6 supplies the storage means 7 with a corresponding input recharge current to a corresponding number of electric charge accumulators 12.

According to the second embodiment of the module 1 shown in the Figures, the module 1 comprises:
- a first parallel connection 6a electrically connected in parallel to a first predefined number of the electric charge accumulators 12;
- a second parallel connection 6b electrically connected in parallel to a second predefined number of electric charge accumulators 12, the first predefined number of electric charge accumulators 12 being different from the second number of electric charge accumulators 12.

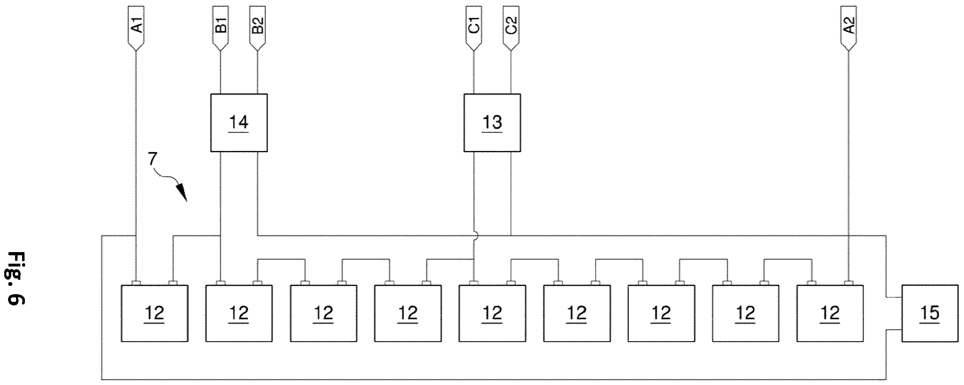

Preferably, as shown in Figure 6, the first parallel connection 6a is electrically connected in parallel to eight electric charge accumulators 12 and the second parallel connection 6b is electrically connected in parallel to five electric charge accumulators 12.; however, alternative embodiments of the module 1 in which the same comprises a different number of parallel connections 6 connected to a different number of electric charge accumulators 12, for example where the module 1 comprises three parallel connections 6 connected in parallel to eight, four and two electric charge accumulators 12 respectively, are not excluded.

The series connections 5 of each of the parallel connections 6 comprise a corresponding predefined number of photovoltaic cells 4 electrically connected in series to each other, in particular, the series connections 5 of at least one of the parallel connections 6 comprise a predefined number of photovoltaic cells 4 different from the predefined number of photovoltaic cells 4 of the series connections 5 of at least other of the connections in parallel 6.
This expedient allows each parallel connection 6 to supply the storage means 7 with a different voltage according to the predefined number of photovoltaic cells 4; in fact, according to the embodiment of the module 1 shown in the figures, the series connections 5 of the first parallel connection 6a comprise a first predefined number of photovoltaic cells 4 and the series connections 5 of the second parallel connection 6b comprise a second predefined number of photovoltaic cells 4 different from the first predefined number of photovoltaic cells 4.

According to the particular embodiment of the module 1 shown in the Figures, the first predefined number of photovoltaic cells 4 is equal to 10 and the second predefined number of photovoltaic cells 4 is equal to 20.
In particular, the photovoltaic group 4, 8 comprises:
- two series connections 5 each provided with 10 photovoltaic cells 4 and electrically connected together in the first parallel connection 6a;
- two series connections 5 each provided with 20 photovoltaic cells 4 and electrically connected to each other in the second parallel connection 6b.

In this way, the first and second parallel connection 6a, 6b respectively generate a first predefined voltage equal to about 6 volts and a second predefined voltage equal to about 12 volts, instead, both the first and the second parallel connection 6a, 6b provide a charging current of approximately 8 amps.

The module 1 comprises at least one DC-DC converter device 13, 14 interposed between each of the parallel connections 6 and the corresponding predefined number of electric charge accumulators 12.
In this way, the voltage supplied by each of the parallel connections 6 is brought to a voltage value comparable to that of the charging voltage supplied by the parallel connection 10.

According to the embodiment of the module 1 shown in the Figure, the module 1 comprises:
- at least a first DC-DC converter device 13 interposed between the first parallel connection 6a and the first predefined number of electric charge accumulators 12;
- at least a second DC-DC converter device 14 interposed between the second parallel connection 6b and the second predefined number of electric charge accumulators 12.

In this way, the first DC-DC converter device 13 converts the first voltage of 6 volts into a voltage equal to approximately 36 volts. Instead, the second DC-DC converter device 14 converts the second voltage of 12 volts into a voltage equal to approximately 90 volts.

The module 1 comprises at least one DC-AC converter device 15 electrically connected to at least one between the parallel connection 10 and the storage means 7, in particular, according to the invention, the DC-AC converter device 15 is connected in parallel to the storage means 7 and to the parallel connection 10, in this way, the DC-AC converter device 15 can convert, according to the needs, the voltage and current supplied by the storage means 7 and/or the voltage and current supplied by the photovoltaic group 4, 8.

The DC-AC converter device 15 is of the inverter type that can be connected to an external electrical network, for example as the domestic electrical network.
The operation of the module 1 according to the invention is described below, when a radiation 3 radiates the photovoltaic group 4, 8, in particular the absorption surface of the photovoltaic cells 4 and of the conversion elements 8, the module 1 converts this radiation into electric energy to be stored in the storage means 7, in particular, the photovoltaic cells 4, electrically connected to each other as described above, apply to the storage means 7 a plurality of charging currents, where each current is applied to a corresponding number of electric charge accumulators 12. At the same time, the conversion elements 8, electrically connected together as previously described, apply to the storage means 7 the recharging voltage necessary to recharge each of the electric charge accumulators 12.

The process to manufacture a photovoltaic module 1 according to the present invention comprises at least the steps of:
- supplying a plurality of photovoltaic cells 4 configured to convert at least a solar type radiation 3 into electric energy and arranged side by side to define an incidence surface 11 of said radiation 3;
- connecting the photovoltaic cells 4 to storage means 7 of said electric charge, the photovoltaic cells 4 supplying the storage means 7 with a recharge current or a recharge voltage of predefined value;
- applying of at least a thickness element 16 on the incidence surface 11, wherein the thickness element 16 is made of transparent material with respect to the radiation 3;
- applying of a plurality of semiconductor conversion elements 8 of the photovoltaic diodes type on the thickness element 16;
- connecting the conversion elements 8 to the storage means 7, the conversion elements 8 supplying the storage means 7 with a recharge voltage suitable to cooperate with the recharge current or, vice versa, a recharge current able to cooperate with the recharge voltage to recharge the storage means 7.

The storage means 7 comprise a plurality of electric charge accumulators 12 electrically connected in series to each other and wherein the step of connecting the photovoltaic cells 4 comprises at least the phases of:
- creating a plurality of series connections 5 of a predefined number of the photovoltaic cells 4;
- creating a plurality of parallel connections 6a, 6b of the series connections 5;
- connecting each of the parallel connections 6a, 6b to a predefined number of the electric charge accumulators 12.

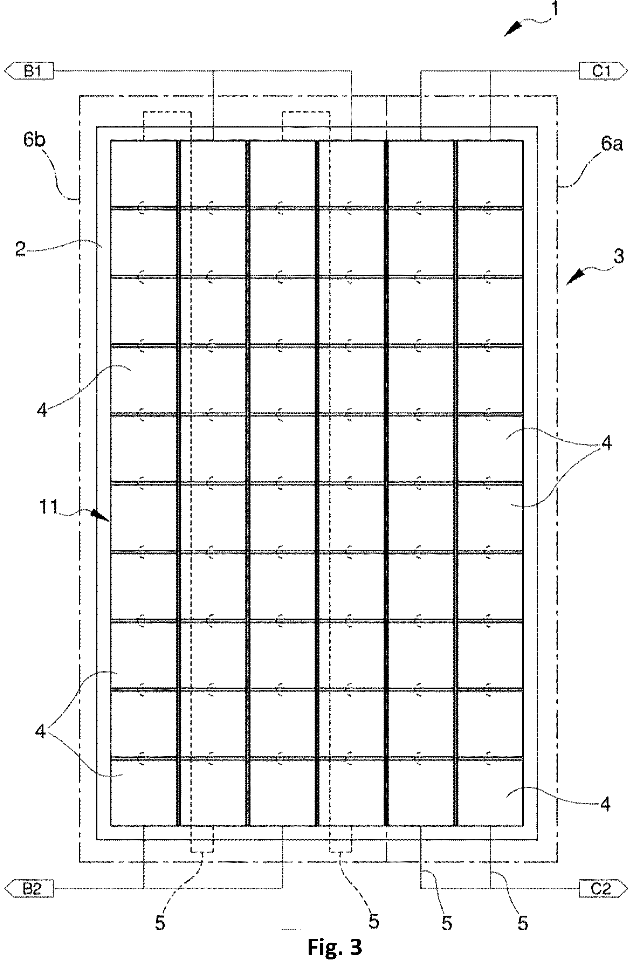

The step of connection of the photovoltaic cells 4 allows to make the electrical connections shown in Figure 3; in fact, with reference to the module 1 previously described, each parallel connection 6a, 6b is connected to a predefined number of electric charge accumulators 12 which number is different with respect to the other parallel connections 6a, 6b; furthermore, the series connections 5 of each parallel connection 6 comprise a different predefined number of photovoltaic cells 4 with respect to the series connections 5 of other parallel connections 6a, 6b.

The step of connecting the conversion elements 8 comprises the phases of:
- creating a plurality of series connections 9 of a predefined number of conversion elements 8;
- creating at least one parallel connection 10 of the series connections 9;
- connecting the parallel connection 10 in parallel to the storage means 7.

The step of connecting the conversion elements 8 allows to make the electric connections shown in Figures 1 and 2.

Preferably, the method comprises at least one step of applicating a further thickness element 16 resting on the conversion elements 8; in addition, the method comprises at least one step of applicating a photovoltaic glass 18 in support of the thickness element 16 resting on the conversion elements 8, so as to manufacture the module 1 shown in figure 5.

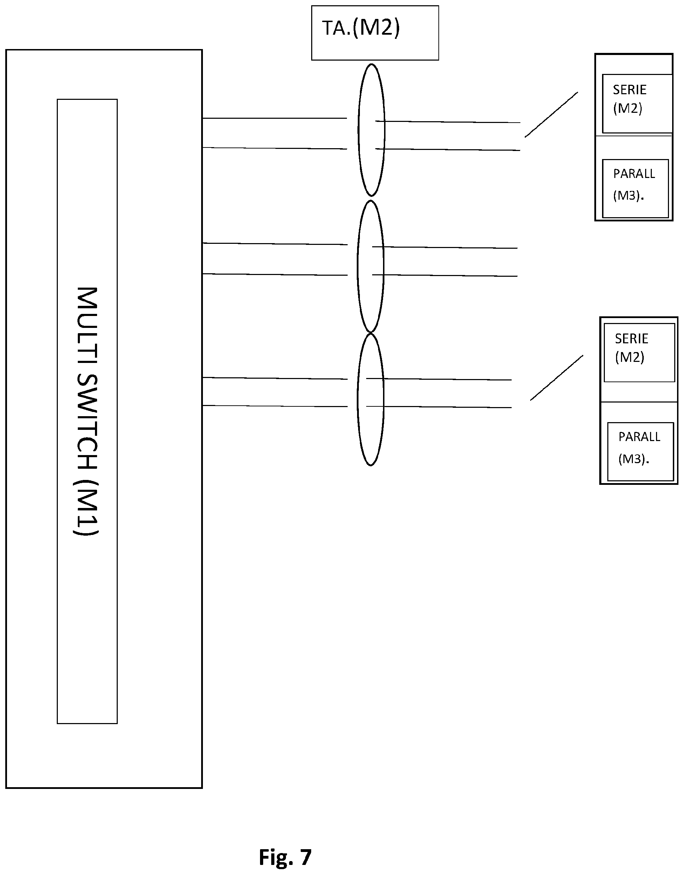

In practice, it has been observed that the described invention achieves the proposed aims of maximizing production also with the aid of a dedicated multi-switch electronics of Figure 7 consisting of a master (M1) consisting of a microprocessor which identifies the best production among series and parallel connections (M3) and (M4), through a CT (Amperometric Transformer) (M2) checking the production based on the power read every 2 minutes.

It should also be noted that the use of a photovoltaic group provided with a plurality of conversion elements that partially cover a plurality of photovoltaic cells allows the photovoltaic module to have dimensions comparable with the dimensions of the photovoltaic modules of know types, but also allows to produce a greater quantity of electricity (this plurality of elements/modules can be connected in series or in parallel).

This arrangement also allows the electric current and the recharging electric voltage of the accumulation means to be kept independent of each other and consequently to make recharging of the latter particularly fast and efficient. In fact, the charging voltage of the storage means is set by the conversion elements and the charging current is set by the photovoltaic cells.

## Claims

1. Photovoltaic module (1) comprising:
• support means (2);
• at least a photovoltaic group (4, 8) mounted on said support means (2), configured to convert at least a solar type radiation (3) incident on said photovoltaic group (4, 8) into electric energy, and comprising at least a plurality of photovoltaic cells (4) electrically connected to each other in at least a plurality of series connection (5) in turn electrically connected to each other in at least a parallel connection (6), said parallel connection (6) is electrically connected to storage means (7) of the electric charge produced by said photovoltaic group and is configured to supply said storage means (7) with a recharge current or a recharge voltage of predefined value;
wherein said photovoltaic group (4, 8) comprises:
• a plurality of semiconductor conversion elements (8) of the photovoltaic diodes type and electrically connected to each other in at least a plurality of series connections (9) in turn electrically connected to each other in at least parallel connection (10), said parallel connection (10) is electrically connected to said storage means (7) and is configured to supply said storage means (7) with a recharge voltage suitable to cooperate with said recharge current or, vice versa, a recharge current able to cooperate with said recharge voltage to recharge said storage means (7).

2. Photovoltaic module (1) according to claim 1, wherein:
• said photovoltaic cells (4) are arranged side by side and define an incidence surface (11) of said radiation (3) to be converted in electric energy; and
• said conversion element (8) are associated with said incidence surface (11).

3. Photovoltaic module (1) according to claim 1, wherein said photovoltaic module (1) comprises at least a thickness element (16) interposed between said incidence surface (11) and said conversion element (8), said thickness element (16) being made of transparent material with respect to said radiation (3).

4. Photovoltaic module (1) according to claim 1, wherein at least part of said conversion element (8) are arranged in a regular way along a plurality of columns substantially parallel to each other.

5. Photovoltaic module (1) according to claim 1, wherein at least part of said conversion element (8) are arranged in a regular way along a plurality of rows substantially parallel to each other and substantially transverse to said plurality of columns.

6. Photovoltaic module (1) according to claim 1, wherein:
• said storage means (7) comprise a plurality of electric charge accumulators (12) electrically connected in series to each other;
• said parallel connection (10) is electrically connected in parallel to said electric charge accumulators (12) electrically connected in series.

7. Photovoltaic module (1) according to claim 1, wherein said series connection (5) are electrically connected to each other in a plurality of parallel connections (6), each of which is electrically connected in parallel to a corresponding predefined number of said electric charge accumulators (12).

8. Photovoltaic module (1) according to claim 1, wherein at least one parallel connection (6) is electrically connected in parallel to a predefined number of said electric charge accumulators (12) different from the predefined number of electric charge accumulators (12) electrically connected in parallel to another of said connections in parallel (6).

9. Photovoltaic module (1) according to claim 1, wherein the series connections (5) of each of said parallel connections (6) comprise a corresponding predefined number of photovoltaic cells (4) electrically connected in series to each other.

10. Photovoltaic module (1) according to claim 1, wherein the series connections (5) of at least one of said parallel connections (6) comprise a predefined number of photovoltaic cells (4) different from the predefined number of photovoltaic cells (4) of the series connections (5) of at least one other of said parallel connections (6).

11. Photovoltaic module (1) according to claim 1, wherein said photovoltaic module (1) comprises at least one DC-DC converter device (13, 14) interposed between each of said parallel connections (6) and said corresponding predefined number of electric charge accumulators (12).

12. Photovoltaic module (1) according to claim 1, wherein said photovoltaic module (1) comprises at least one DC-AC converter device (15) electrically connected to at least one between said parallel connection (10) and said storage means (7).

13. Process to manufacture a photovoltaic module (1) comprising at least the steps of:
• supplying a plurality of photovoltaic cells (4) configured to convert at least a solar type radiation (3) into electric energy and arranged side by side to define an incidence surface (11) of said radiation (3);
• connecting said photovoltaic cells (4) to storage means (7) of said electric charge, said photovoltaic cells (4) supplying said storage means with a recharge current or a recharge voltage of predefined value;
• applying of at least a thickness element (16) on said incidence surface (11), wherein said thickness element (16) is made of transparent material with respect to said radiation (3);
• applying of a plurality of semiconductor conversion elements (8) of the photovoltaic diodes type on said thickness element (16);
• connecting said conversion elements (8) to said storage means (7), said conversion elements (8) supplying said storage means (7) with a recharge voltage suitable to cooperate with said recharge current or, vice versa, a recharge current able to cooperate with said recharge voltage to recharge said storage means (7).

14. Process according to claim 13, wherein said storage means (7) comprise a plurality of electric charge accumulators (12) electrically connected in series to each other and wherein said step of connecting said photovoltaic cells (4) comprises at least the phases of:
• creating a plurality of series connections (5) of a predefined number of said photovoltaic cells (4);
• creating a plurality of parallel connections (6) of said series connections (5);
• connecting each of said parallel connections (6) to a predefined number of said electric charge accumulators (12).
